# EUROPEAN PATENT APPLICATION

(11) **EP 2 226 642 A1**
(43) Date of publication of application: **08.09.2010**
(21) Application number: 09154413.0
(22) Date of filing: 05.03.2009
(51) Int. Cl.: G01R 31/36, H02J 7/00

(54) **A method and a device for verifying the capacity of an emergency battery**

(71) Applicant: SafeLine Europe, 1200 Woluwé-Saint-Lambert (BE)
(72) Inventor: Odlén, Lars, 1150, BRUSSELS (BE); Jäderberg, Tomas, 13554, TYSERÖ (SE)
(74) Representative: Quintelier, Claude

(57) **Abstract**

A method for verifying a capacity of an emergency battery (8) of an elevator, wherein said emergency battery is connected to an emergency circuit enabling a standby current to flow towards an emergency device, said battery being connected to a charging circuit (14) in which a charging current flows for charging said emergency battery, a load current, which is substantially higher than the charging current, being retrieved from said emergency battery and supplied to an impedance (24) during a predetermined period of a least 30ms and wherein within said load current retrieval period, the voltage of the battery under load is measured, the latter being then compared with a reference voltage value for said emergency battery, and wherein a failure signal is generated, when upon said comparison it is determined that said measured voltage exceeds a predetermined difference value with respect to said reference voltage value.

## Description

The present invention relates to a method for verifying a capacity of an emergency battery of an elevator, wherein said emergency battery is connected to an emergency circuit enabling a standby current to flow towards an emergency device, said battery being connected to a charging circuit in which a charging current flows for charging said emergency battery.

Such a method is imposed by EU regulations. The EU elevator code requires that the emergency battery, used in particular for light and emergency phones, has at least one hour capacity in the event of a power failure. This should be regularly checked, since the lead acid battery types, generally used for emergency batteries, have a tendency of diminishing their capacity over the years, in particular due to oxidation or corrosion occurring on the cathode and anode plates. Measuring the voltage on the battery poles as such does not provide a reliable information as the voltage tends to remain stable regardless the battery's remaining capacity, in particular since the battery is normally being constantly charged.

A reliable way to verify the capacity is to disconnect the mains power supply and wait for the mandated one hour before testing the elevator's emergency devices. However, a drawback of the latter solution, is that it is time consuming, which in practice often leads to that no verification is done, thereby taking the risk that the emergency battery does not work when needed; i.e. when indeed there is a power failure and someone is trapped in the elevator.

An object of the present invention is to provide a method and device which enables a reliable verification of the capacity of the emergency battery and, which moreover, can be performed quickly and frequently.

For this purpose a method for verifying the capacity of an emergency battery of an elevator is **characterised in that** a load current, which is substantially higher than the charging current, is retrieved from said emergency battery and supplied to an impedance during a predetermined period of a least 30ms and wherein within said load current retrieval period, the voltage of the battery under load is measured, the latter being then compared with a reference voltage value for said emergency battery, and wherein a failure signal is generated, when upon said comparison it is determined that said measured voltage exceeds a predetermined difference value with respect to said reference voltage value. By selecting a load current substantially higher than the charging current, the value of the charging current becomes irrelevant with respect to the load current, so that the measurement reflects principally the condition of the battery itself. As the capacity held by the battery is dependent from the operating conditions of the anode and the cathode, plus the general condition of the battery, this voltage measurement when the battery is under load gives a good indication of the battery's internal impedance, which principally reflects the battery's condition. The comparison with a stored reference voltage value for the same emergency battery will permit to automatically establish whether or not the capacity of the battery is sufficient. If the measured load voltage is beneath a predetermined difference value, this will indicate a malfunctioning of the battery and thus a failure signal will be generated. As this operation can be done quickly and in a reliable manner, the imposed battery verification becomes more easy to perform, thereby creating a tool which will enable to conform with the imposed EU verification.

A first preferred embodiment of a method according to the invention is **characterised in that** said predetermined period is at most 500ms. By limiting the time during which the load current is retrieved from the battery to 500 ms at most, the discharge imposed on the battery is insignificant and the current peak will not adversely affect the battery.

A second preferred embodiment of a method according to the invention is **characterised in that** said measuring of the battery voltage is started after a transient period, starting from the moment at which the load current is retrieved from the battery. In such a manner a stabilisation occurred and it is avoided that transient effects would adversely affect the measurement.

A third preferred embodiment of a method according to the invention is **characterised in that** said load current is retrieved periodically. In such a manner a periodic check is realised, which enables to fully comply with the imposed EU regulations.

A fourth preferred embodiment of a method according to the invention is **characterised in that** said load current is at least 30 % higher than said charging current. This enables to clearly distinguish the load current from the charging current and thus obtain a reliable measurement.

The invention also relates to a device for verifying the capacity of an emergency battery of an elevator. Such a device is **characterised in that** it comprises an impedance circuit provided to be connected to said battery and for retrieving during a predetermined period of at least 30 ms a load current from said emergency battery and for supplying said load current to an impedance of said impedance circuit, which load current is substantially higher than said charging current, said device further comprising a memory for storing a measured reference voltage value for said emergency battery, said device also comprising a measurement member having a comparator and provided for measuring a voltage of the battery within said predetermined period and for comparing said measured voltage with said reference voltage value and generating a failure signal upon determining that said measured voltage value exceeds a predetermined difference value with respect to said reference voltage value.

The invention will now be described in more details with reference to the annexed drawings. In the drawings :
figure 1 illustrates schematically an elevator provided with the imposed security means;
figure 2 illustrates, by means of an electric circuit how the method according to the invention is implemented; and
figure 3 shows a time-voltage diagram illustrating the application of the load current.

In the drawings a same reference sign has been allocated to a same or an analogous element.

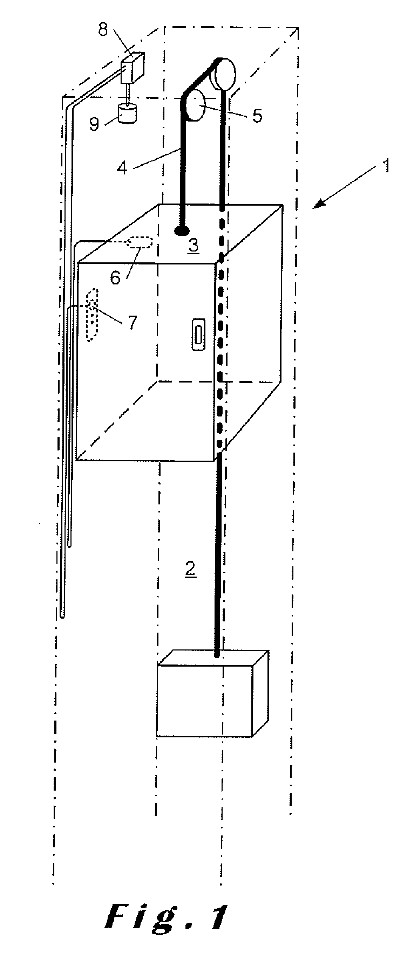

Figure 1 illustrates an elevator set-up having an elevator car 3 moving up and down in an elevator shaft 2. The elevator car is suspended on a rope 4 applied on a pulley 5. The elevator car is foreseen, as imposed by security regulations, with an emergency telephone 7 and an emergency light 6. As the telephone and the emergency light should remain powered with electrical current, even in case of a mains power failure, an emergency battery 8 is mounted, typically in the elevator machine-room. A device 9 for verifying the capacity of the emergency battery 8 is connected to the battery. The latter device can either be permanently connected and operate fully automatically or can be plugged in by an inspector when the latter comes to verify the capacity of the emergency battery.

EU - regulation EN 81 - 28 ; 2003 stipulates under 4.1.3 "Any alarm shall not be impeded or lost even in cases of electrical power supply switching or power supply failure. Where a rechargeable emergency electrical power supply is used, means shall be provided to inform automatically the rescue service as soon as the capacity is lower than needed to provide one hour of function of the alarm system". A manner to control this is to switch off the mains and wait for one hour. If thereafter the battery still supplies sufficient electrical power to the emergency devices, the check conditions are fulfilled. This procedure is however cumbersome, time consuming and therefore such verifications are often not carried out.

The method and the device according to the present invention for verifying the capacity of an emergency battery enables to solve the above mentioned problem in that it offers a regularly and a more cost efficient way to comply with the imposed regulations, thereby substantially reducing the risk that the emergency battery fails to operate when required.

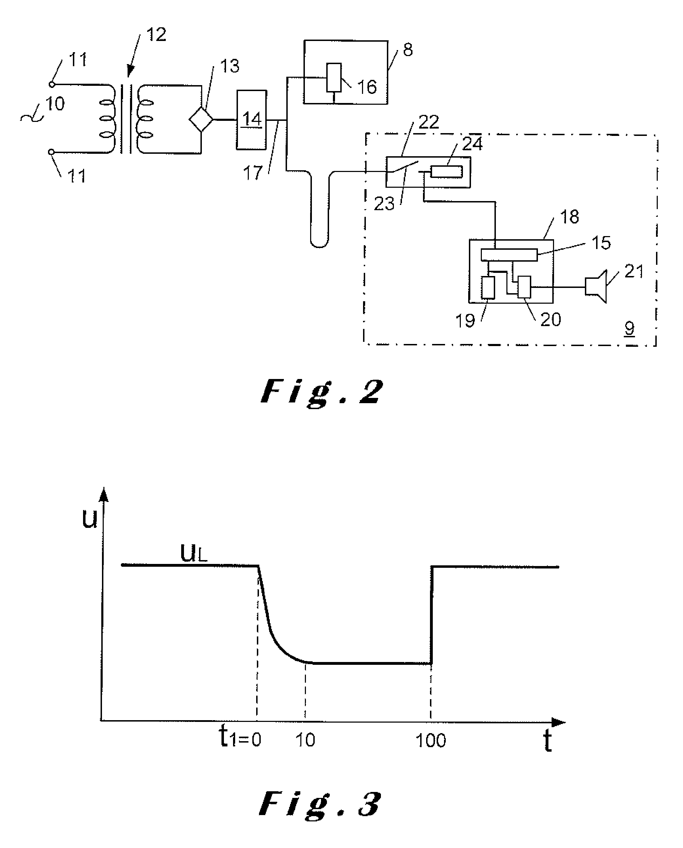

Figure 2 illustrates an electric circuit enabling to perform the verification method. The circuit is connectable to the mains 10 by means of a plug 11. The circuit comprises a transformer 12 and a rectifier bridge 13 for converting an AC of for example 240 V into a supply of for example 12 V DC. It will be clear that the values of 240 V and 12 V are given by way of example and in no way limit the scope of protection.

An output of the rectifier bridge 13 is connected to a charging circuit 14 provided for regulating the supply of a charging current IC to the battery 8. A wire 17 connects the charging circuit output 14 to the battery 8 in order to supply the charging current IC to the battery. The impedance of the battery is illustrated by reference 16.

The device 9 for verifying the battery capacity comprises a switch 23 and a load 24, the latter being for example formed by a resistor. The device 9 is also connected to the wire 17 and comprises further a measurement member 18..The measurement member comprises a voltage measurement device 15, a memory 19 and a comparator 20, which are connected to each other. An alarm generator 21 is connected to an output of the measurement member 18.

For measurement purpose, the load device is connected to the battery during a predetermined period of at least 30 ms and preferably during a period of 100 ms, in order not to discharge the battery, which could cause damage.

In order to verify the remaining battery capacity, the battery has to be measured under load. Due to aging, a battery has a tendency to lose capacity because the anode and cathode plate surface will shrink due to oxidation or corrosion. Another problem that could affect the battery capacity is the loss of electrolyte due to evaporation or changed chemical composition. The battery's open voltage, i.e. non load condition, is not a reliable indicator of the condition because of the electro chemical process which maintains the voltage, despite the diminishing of capacity over time. Further the battery is normally being permanently charged, which means that any such measurement would measure the condition of the charger, rather than the actual battery. Due to the location of the battery being physically distant from the emergency devices, it is impractical or even impossible to switch the charging off. However, if a load current substantially higher than the stand by charging current is connected during said predetermined period, the capacity of the battery can be verified. If the battery's capacity is reduced, due to reduced surface of the anode or cathode plate, or due to a changed chemical composition of the electrolyte, the battery will, due to increased internal impedance, not be able to withstand this load current without a detectable reduction of voltage, one can thereby obtain a reliable picture of the battery's remaining capacity.

The load current IL should not be retrieved during a period of more than typ 500 ms, in order to minimise the power dissipation in the battery and in the load circuit. A load current of at least 30 % higher than the charging current is an appropriate choice for minimising the power dissipation. A value higher than 80 % of the charging current would not lead to an improved result.

The load current should preferably be retrieved periodically, for example once every day or every week. For this purpose a clock unit should be included into the charging circuit. In such a manner, a periodic control is possible, satisfying the EU elevator directive.

In order to connect the load current to the battery, the device will close the switch 15 during the predetermined load period, so that the load current IL is retrieved from the battery. As illustrated in figure 3, the load current shows a transient period, due to inductive and electrochemical reactions, of for example 10 ms after the time t1 = 0 at which the switch 15 is activated. During this transient period, transient effects could adversely affect the measurement.

The battery's voltage Uₗ under load is measured within the predetermined period by the measurement member 18 and compared thereafter by means of the comparator 20 to a reference voltage value Uₗᵣ for the said emergency battery 8. The reference value Uₗᵣ is stored in the memory 19 and has been preferably obtained upon initialisation. For this purpose a load current is retrieved from the battery, when installed or commissioned, and a battery voltage under load Uₗᵣ is measured and stored as a reference value in the memory. The highest stable value is preferably determined through a series of consecutive measurements, thereby avoiding the storing of values referring to a semi discharged battery, as would have been the case when the charging circuit has been disconnected, for instance during transportation, storage or installation. This highest stable value is kept as the reference value to which following measurements are compared. Of course, it would also be possible to store a predetermined Uₗᵣ value into the memory, this presuming the capacity and properties of the battery are known.

The comparator 19 compares Uₗ with Uₗᵣ and determines when Uₗ exceeds a predetermined difference value Δ with respect to Uₗᵣ. This predetermined difference value Δ is for example situated between 5 % and 30 %. So, when |*Uₗ* -*Uₗᵣ* |>Δ the measurement member generates a failure signal which is supplied to the alarm signal generator 21. The latter is for example formed by a LED or other indicating device, but could also be formed by the generation of a message to a supervision centre. In such a manner an automatic and fast verification of the battery becomes possible, thereby enabling to comply with the imposed EU safety regulations.

## Claims

1. A method for verifying a capacity of an emergency battery of an elevator, wherein said emergency battery is connected to an emergency circuit enabling a standby current to flow towards an emergency device, said battery being connected to a charging circuit in which a charging current flows for charging said emergency battery, **characterised in that** a load current, which is substantially higher than the charging current, is retrieved from said emergency battery and supplied to an impedance during a predetermined period of a least 30ms and wherein within said load current retrieval period, the voltage of the battery under load is measured, the latter being then compared with a reference voltage value for said emergency battery, and wherein a failure signal is generated, when upon said comparison it is determined that said measured voltage exceeds a predetermined difference value with respect to said reference voltage value.

2. A method as claimed in claim 1, **characterised in that** said predetermined period is at most 500 ms, preferably 100 ms.

3. A method as claimed in claim 1 or 2, **characterised in that** said measuring of the battery voltage is started after a transient period starting from the moment at which the load current is retrieved from the battery.

4. A method as claimed in claim 3, **characterised in that** said transient period is about 10 ms.

5. A method as claimed in any one of the claims 1 to 4, **characterised in that** said predetermined difference value is situated between 5 % and 30 % of the reference voltage value.

6. A method as claimed in any one of the claims 1 to 5, **characterised in that** said load current is retrieved periodically.

7. A method as claimed in any one of the claims 1 to 6, **characterised in that** said load current is at least 30 % higher than said charging current.

8. A device for verifying a capacity of an emergency battery of an elevator, said emergency battery being connectable to a charging circuit for providing a charging current for charging said emergency battery, **characterised in that** it comprises an impedance circuit provided to be connected to said battery and for retrieving during a predetermined period of at least 30 ms a load current from said emergency battery and for supplying said load current to an impedance of said impedance circuit, which load current is substantially higher than said charging current, said device further comprising a memory for storing a measured reference voltage value for said emergency battery, said device also comprising a measurement member having a comparator and provided for measuring a voltage of the battery within said predetermined period and for comparing said measured voltage with said reference voltage value and generating a failure signal upon determining that said measured voltage value exceeds a predetermined difference value with respect to said reference voltage value.
